(19) **Europäisches Patentamt / European Patent Office / Office européen des brevets**

(11) **EP 4 760 687 A1**

(12) **EUROPEAN PATENT APPLICATION**

(43) Date of publication:
**17.06.2026 Bulletin 2026/25**

(21) Application number: **25214440.7**

(22) Date of filing: **07.11.2025**

(51) International Patent Classification (IPC):
**G09G 3/32** (2016.01)    **H10K 59/35** (2023.01)

(52) Cooperative Patent Classification (CPC):
**G09G 3/32; G09G 3/3266; H10K 59/352;**
G09G 2300/0426; G09G 2300/0861;
G09G 2320/0223

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.12.2024 CN 202411820420**

(71) Applicant: **Tianma Advanced Display Technology
Institute
(Xiamen) Co., Ltd.
361101 Xiamen (CN)**

(72) Inventors:
• ZHAI, Yingteng
  Xiamen, 361101 (CN)
• HU, Yuqi
  Xiamen, 361101 (CN)
• WU, Yingying
  Xiamen, 361101 (CN)
• CHEN, Wang
  Xiamen, 361101 (CN)

(74) Representative: **Boult Wade Tennant LLP
Salisbury Square House
8 Salisbury Square
London EC4Y 8AP (GB)**

(54) **DISPLAY PANEL AND DISPLAY APPARATUS**

(57) A display panel (100) comprises sub-pixels (1,2,3) and light-emitting control signal lines (EM1,EM2). The sub-pixels comprise a first sub-pixel (1) and a second sub-pixel (2). The first sub-pixel (1) comprises a first transistor (11), the second sub-pixel (2) comprising a second transistor (22). The light-emitting control signal lines comprise a first light-emitting control signal line (EM1) and a second light-emitting control signal line (EM2). A gate of the first transistor (11) is connected to the first light-emitting control signal line and a gate of the second transistor (22) is connected to the second light-emitting control signal line. A channel area of the first transistor (11) and a channel area of the second transistor (22) are different. The display panel (100) can solve a color cast problem.

FIG. 3

EP 4 760 687 A1

## Description

### TECHNICAL FIELD

The present application relates to the technical field of display, and in particular to a display panel and a display apparatus.

### BACKGROUND

Flat panel display apparatuses based on technology such as light-emitting diodes (LEDs) have been widely used in various consumer electronic products such as mobile phones, televisions, laptops, and desktop computers due to their advantages such as high image quality, power saving, thin body, and wide range of applications, becoming the mainstream among display apparatuses.

However, with the development of display technology, the functions of display panels are becoming more and more diverse, and the performance indicators of display panels are becoming higher and higher. For example, the users expect the display effects of the display panels to be better and better. However, the display panels in the related art still have the problem of color cast.

### SUMMARY

Embodiments of the present application provide a display panel and a display apparatus to solve a color cast problem.

In a first aspect, an embodiment of the present application provides a display panel. The display panel comprises sub-pixels and light-emitting control signal lines. The sub-pixels comprise a first sub-pixel and a second sub-pixel. The first sub-pixel comprises a first transistor, the second sub-pixel comprising a second transistor. The light-emitting control signal lines comprise a first light-emitting control signal line and a second light-emitting control signal line. A gate of the first transistor is connected to the first light-emitting control signal line and a gate of the second transistor is connected to the second light-emitting control signal line. A channel area of the first transistor and a channel area of the second transistor are different.

In a second aspect, based on a same inventive concept, an embodiment of the present application provides a display apparatus comprising the display panel according to the embodiment of the first aspect.

Other embodiments in the summary are as disclosed in the claims as appended.

In the display panel and the display apparatus according to the embodiments of the present application, the first transistor of the first sub-pixel is connected to the first light-emitting control signal line, the second transistor of the second sub-pixel is connected to the second light-emitting control signal line, and the channel area of the first transistor is different from the channel area of the second transistor. In this way, the magnitude relationship between the channel area of the first transistor and the channel area of the second transistor can be flexibly designed according to the load magnitude of the first light-emitting control signal line and the load magnitude of the second light-emitting control signal line, which can ensure that the overall load of the first light-emitting control signal line and the overall load of the second light-emitting control signal line tend to be consistent, thereby ensuring that the delays of the signals on the first light-emitting control signal line and the second light-emitting control signal line tend to be consistent, so that the light-emitting time of the first sub-pixel and the light-emitting time of the second sub-pixel can be matched according to the target ratio, which is conducive to solving the problem on the color cast in the displayed image.

### BRIEF DESCRIPTION OF THE DRAWINGS

Other features, objects, and advantages of the present application will become more apparent from the following detailed description of non-limiting embodiments taken with reference to the drawings. The same or similar reference numerals refer to same or similar features, the drawings are not drawn to actual scale.

FIG. 1 is a schematic structural diagram of a display panel provided by an embodiment of the present application.
FIG. 2 is a schematic diagram of a circuit topology of a sub-pixel in a display panel provided by an embodiment of the present application.
FIG. 3 is a schematic structural diagram of another display panel provided by an embodiment of the present application;
FIG. 4 is a schematic diagram of another circuit topology of a sub-pixel in a display panel provided by an embodiment of the present application.
FIG. 5 is a schematic diagram of a layout structure of a local area in a display panel provided by an embodiment of the present application.

FIG. 6 is a schematic diagram of another circuit topology of a sub-pixel in a display panel provided by yet an embodiment of the present application.

FIG. 7 is a schematic diagram of another circuit topology of a sub-pixel in a display panel provided by an embodiment of the present application.

FIG. 8 is a schematic structural diagram of another display panel provided by an embodiment of the present application.

FIG. 9 is a schematic diagram of another circuit topology of a sub-pixel in a display panel provided by an embodiment of the present application.

FIG. 10 is a schematic structural diagram of another display panel provided by an embodiment of the present application.

FIG. 11 is a schematic structural diagram of a driving circuit in a display panel provided by an embodiment of the present application.

FIG. 12 is a schematic diagram of another circuit topology of a sub-pixel in a display panel provided by an embodiment of the present application.

FIG. 13 is a timing diagram of a display panel provided by an embodiment of the present application.

FIG. 14 is a schematic structural diagram of a display apparatus provided by an embodiment of the present application.

## DETAILED DESCRIPTION

Hereinafter, features and exemplary embodiments of various aspects of the present application will be described in detail, and in order to make the purpose, technical solution, and advantages of the present application more clearly understood, the present application will be described in further detail below with reference to the drawings and specific embodiments. It is to be understood that the specific embodiments described herein are merely configured to explain the present application, and are not configured to limit the present application. It will be apparent to those skilled in the art that the present application may be practiced without the need for some of these specific details. The following description of embodiments is merely for the purpose of providing a better understanding of the present application by illustrating examples thereof.

It should be noted that, herein, relational terms such as first and second are used merely to distinguish one entity or operation from another entity or operation, and do not necessarily require or imply that any such actual relationship or order exists between these entities or operations. Moreover, the terms "include," "comprise," or any other variation thereof are intended to encompass a non-exclusive inclusion such that a process, method, article, or device that includes a series of elements includes not only those elements, but also other elements that are not explicitly listed, or elements inherent to such a process, method, article, or device. Without further limitation, an element defined by the statement "comprising" does not preclude the presence of additional identical elements in a process, method, article, or device comprising the element.

It should be understood that when describing the structure of a component, when a layer or region is referred to as being "above" or "top" another layer or region, it may mean that it is directly above the other layer or region, or that other layers or regions are also included between it and the other layer or region. And, if the component is turned over, the layer or region will be "below" or "under" the other layer, region.

It should be understood that the term "and/or" as used herein is merely an association relationship describing an association object, indicating that there may be three relationships. For example, A and/or B, which may mean that there are three cases that A exists alone, A and B exist at the same time, and B exists alone. In addition, the character "/" in the present application generally indicates that the associated objects are in an "or" relationship.

In the embodiments of the present application, the term "electrically connected" may mean that two components are directly electrically connected, or may mean that two components are electrically connected via one or more other components.

The term "connected" may mean "electrically connected" or " electrically connected not through an intermediate transistor". The term "insulated" may refer to "electrically insulated" or "electrically isolated". The term "drive" can refer to "control" or "operation". The term "part" may refer to "partial". The term "pattern" may refer to a "member". The term "end" may refer to an "end segment" or an "end edge". The display panel may be a display apparatus or a module/part of a display apparatus.

It is apparent for those skilled in the art that various modifications and variations can be made in the present application without departing from the gist or scope of the present application. Accordingly, the present application is intended to cover modifications and variations of the present application that fall within the scope of the corresponding claims (claimed technical solutions) and their equivalents. It should be noted that the embodiments provided in the embodiments of the present application can be combined with each other unless there is no contradiction.

Before describing the technical solutions provided by the embodiments of the present application, in order to facilitate understanding of the embodiments of the present application, the present application first specifically describes the problems existing in the related art:

The display panel usually includes sub-pixels of a plurality of light-emitting colors, the sub-pixels are connected to light-emitting control signal lines, and the light-emitting control signals on the light-emitting control signal lines control whether the sub-pixels emit light.

In view of the different characteristics of the sub-pixels of different light-emitting colors, in some implementations, the sub-pixels of different light-emitting colors can be connected to different light-emitting control signal lines, so that the sub-pixels of different light-emitting colors can be separately controlled based on different light-emitting control signals.

However, the inventors have found that the loads of different light-emitting control signal lines may be different, resulting in different delays of signals on different light-emitting control signal lines, resulting in the inability to accurately control the light-emitting times of the sub-pixels of different light-emitting colors, and thus the light-emitting times of the sub-pixels of different light-emitting colors may be mismatched, resulting in the color cast of the displayed picture.

In order to solve the above technical problems, an embodiment of the present application provides a display panel and a display apparatus. The technical concept of the present application includes: differentiating the design of channel areas of transistors connected to different light-emitting control signal lines, thereby balancing the loads of different light-emitting control signal lines, so that the delays of signals on different light-emitting control signal lines tend to be consistent, so as to solve the color cast problem.

Hereinafter, the embodiments of a display panel and a display apparatus provided in the present application will be described with reference to the drawings.

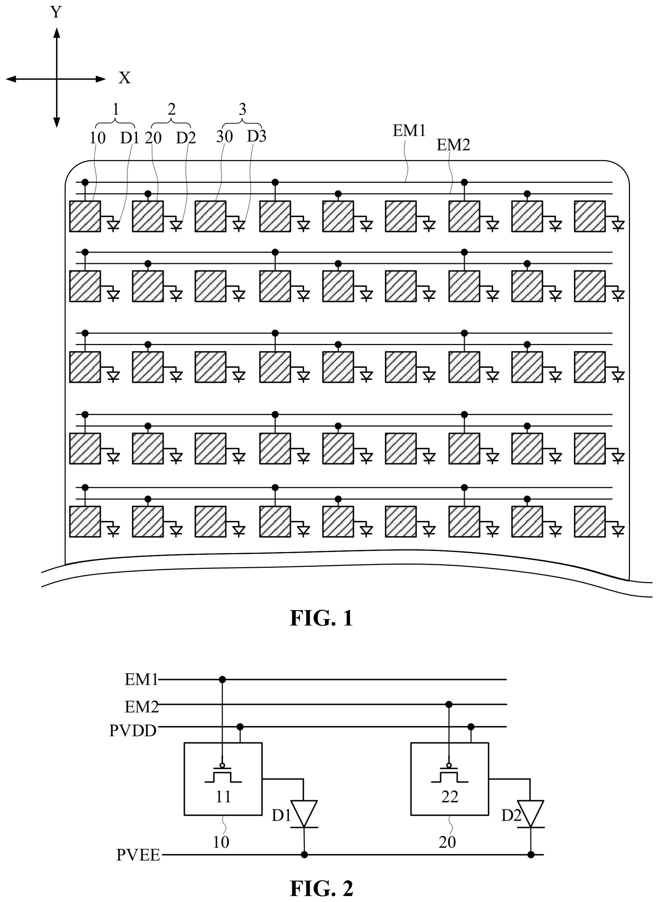

As shown in FIG. 1, the display panel provided by the embodiments of the present application includes sub-pixels and light-emitting control signal lines. The sub-pixels include a first sub-pixel 1 and a second sub-pixel 2. The light-emitting control signal lines include a first light-emitting control signal line EM1 and a second light-emitting control signal line EM2.

Exemplarily, the light-emitting colors of the first sub-pixel 1 and the second sub-pixel 2 are different. The first sub-pixel 1 includes a first pixel circuit 10 and a first light-emitting element D1. The first pixel circuit 10 is connected to the first light-emitting control signal line EM1 and the first light-emitting element D1, and the first pixel circuit 10 is controlled by the first light-emitting control signal on the first light-emitting control signal line EM1 to further control whether the first light-emitting element D1 emits light.

The second sub-pixel 2 includes a second pixel circuit 20 and a second light-emitting element D2. The second pixel circuit 20 is connected to the second light-emitting control signal line EM2 and the second light-emitting element D2, and the second pixel circuit 20 is controlled by the second light-emitting control signal on the second light-emitting control signal line EM2 to further control whether the second light-emitting element D2 emits light.

As shown in FIG. 2, the first pixel circuit 10 in the first sub-pixel includes a first transistor 11, and a gate of the first transistor 11 is connected to the first light-emitting control signal line EM1. The first light-emitting control signal on the first light-emitting control signal line EM1 can control the state of the first transistor 11. For example, when the first light-emitting control signal on the first light-emitting control signal line EM1 is at an active level, the first transistor 11 is turned on and the first light-emitting element D1 emits light. When the first light-emitting control signal on the first light-emitting control signal line EM1 is at a cut-off level, the first transistor 11 is turned off, and the first light-emitting element D1 does not emit light.

The second pixel circuit 20 in the second sub-pixel includes a second transistor 22. A gate of the second transistor 22 is connected to the second light-emitting control signal line EM2. The second light-emitting control signal on the second light-emitting control signal line EM2 can control the state of the second transistor 22. For example, when the second light-emitting control signal on the second light-emitting control signal line EM2 is at an active level, the second transistor 22 is turned on and the second light-emitting element D2 emits light. When the second light-emitting control signal on the second light-emitting control signal line EM2 is at a cut-off level, the second transistor 22 is turned off and the second light-emitting element D2 does not emit light.

In the present application, the "active level" refers to a level configured to control the transistor to be turned on (conduct), and the "cut-off level" refers to a level configured to control the transistor to be turned off (shut down). If the transistor is a P-type transistor, the "active level" is low level and the "cut-off level" is high level. If the transistor is an N-type transistor, the "active level" is high level and the "cut-off level" is low level. In the drawings of the present application, the transistor is schematically illustrated as a P-type transistor, which is not intended to limit the present application.

The channel area of the first transistor 11 and the channel area of the second transistor 12 are different.

The channel area is the product of the channel length and the channel width. The active layer of the transistor includes a channel, and a source region and a drain region that are located on both sides of the channel respectively. The channel of the transistor overlaps the gate of the transistor, while the source region and the drain region do not overlap the gate. The channel of the transistor overlaps the gate of the transistor to form a parasitic capacitance of the transistor, which constitutes an important part of the load of the trace connected to the gate of the transistor. The size of the parasitic capacitance is affected by the channel area. The larger the channel area, the greater the parasitic capacitance and the greater the load on the trace connected to a gate of the transistor. The smaller the channel area, the less the parasitic capacitance and the less the load on the trace connected to the gate of the transistor. Therefore, the channel area of the first transistor 11 may affect the load of the first light-emitting control signal line EM1, and the channel area of the second transistor 12 may affect the load of the second light-emitting control signal line EM2.

Exemplarily, the magnitude relationship between the channel area of the first transistor 11 and the channel area of the second transistor 12 can be designed according to the actual situation. For example, in a case that the load of the first light-emitting control signal line EM1 is smaller than the load of the second light-emitting control signal line EM2 due to other factors, the channel area of the first transistor 11 may be designed to be larger than the channel area of the second transistor 12. For another example, in a case that the load of the first light-emitting control signal line EM1 is greater than the load of the second light-emitting control signal line EM2 due to other factors, the channel area of the first transistor 11 can be designed to be smaller than the channel area of the second transistor 12. As a result, the overall load of the first light-emitting control signal line EM1 and the overall load of the second light-emitting control signal line EM2 tend to be consistent.

It should be noted that, in FIG. 2, only the first transistor 11 in the first pixel circuit 10 and the second transistor 22 in the second pixel circuit 20 are illustrated, and the first pixel circuit 10 and the second pixel circuit 20 can also include other transistors. For example, each of the first pixel circuit 10 and the second pixel circuit 20 further includes a driving transistor, a transistor for writing a data voltage, a transistor for performing threshold compensation, a transistor for writing a reset voltage, and so on. The present application does not limit the specific structure of the pixel circuit.

In addition, only one first transistor 11 in the first pixel circuit 10 and one second transistor 22 in the second pixel circuit 20 are shown in FIG. 2. The number of first transistors 11 in the first pixel circuit 10 may be more than one, and the number of second transistors 22 in the second pixel circuit 20 may be also more than one. In a case that the first pixel circuit 10 includes a plurality of first transistors 11 and the second pixel circuit 20 includes a plurality of second transistors 22, the channel area of at least one first transistor 11 is different from the channel area of at least one second transistor 22.

According to the display panel provided by the embodiments of the present application, the first transistor of the first sub-pixel is connected to the first light-emitting control signal line, the second transistor of the second sub-pixel is connected to the second light-emitting control signal line, and the channel area of the first transistor is different from the channel area of the second transistor. In this way, the magnitude relationship between the channel area of the first transistor and the channel area of the second transistor can be flexibly designed according to the load magnitude of the first light-emitting control signal line and the load magnitude of the second light-emitting control signal line, which can ensure that the overall load of the first light-emitting control signal line and the overall load of the second light-emitting control signal line tend to be consistent, thereby ensuring that the delays of the signals on the first light-emitting control signal line and the second light-emitting control signal line tend to be consistent, so that the light-emitting time of the first sub-pixel and the light-emitting time of the second sub-pixel can be matched according to the target ratio, thereby solving the problem of color cast in the displayed image.

In some embodiments, as shown in FIGS. 1, 3, and 4, the display panel further includes a third sub-pixel 3. Exemplarily, the light-emitting colors of the first sub-pixel 1, the second sub-pixel 2, and the third sub-pixel 3 are different from one another. For example, one of the first sub-pixel 1, the second sub-pixel 2, and the third sub-pixel 3 is a red sub-pixel, another one is a green sub-pixel, and yet another one is a blue sub-pixel. The first sub-pixel 1, the second sub-pixel 2, and the third sub-pixel 3 constitute one pixel unit PU, and a plurality of the pixel units PU are arranged in an array in the first direction X and the second direction Y, where the first direction X and the second direction Y intersect. Exemplarily, the first light-emitting control signal line EM1 and the second light-emitting control signal line EM2 extend in the first direction X. For example, the first direction X is a row direction, a plurality of first sub-pixels 1 located in the same row are connected to the same first light-emitting control signal line EM1, and a plurality of second sub-pixels 2 and a plurality of third sub-pixels 3 located in the same row are connected to the same second light-emitting control signal line EM2.

The third sub-pixel 3 includes a third pixel circuit 30 and a third light-emitting element D3. The third pixel circuit 30 is connected to the second light-emitting control signal line EM2 and the third light-emitting element D3, and the third pixel circuit 30 is controlled by the second light-emitting control signal on the second light-emitting control signal line EM2 to further control whether the third light-emitting element D3 emits light. In this example, the second sub-pixel 2 and the third sub-pixel 3 are both connected to the second light-emitting control signal line EM2, and the number of sub-pixels connected to the second light-emitting control signal line EM2 is larger than the number of sub-pixels connected to the first light-emitting control signal line EM1.

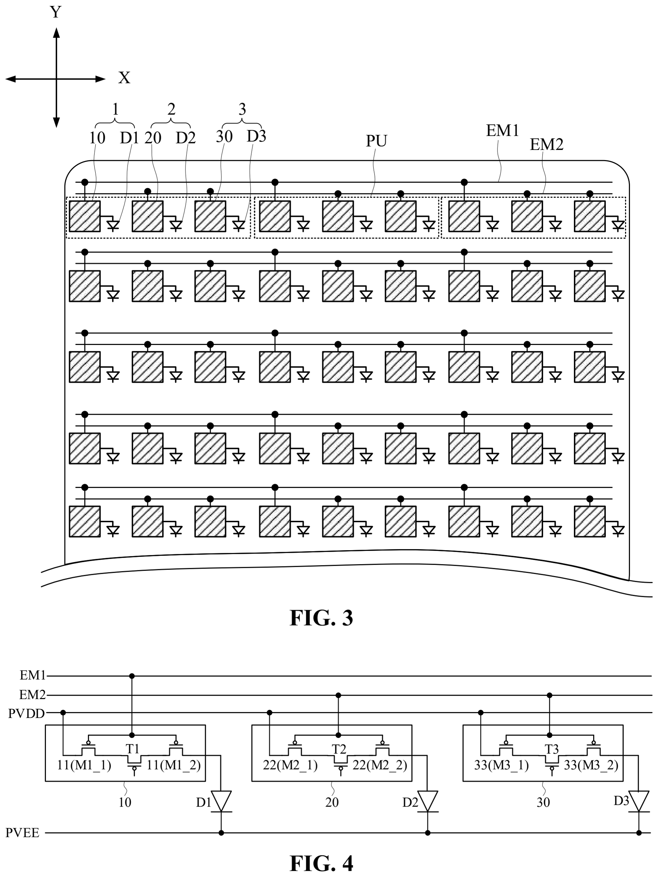

As shown in FIG. 4, the third pixel circuit 30 in the third sub-pixel includes a third transistor 33, and a gate of the third transistor 33 is connected to the second light-emitting control signal line EM2. The second light-emitting control signal on the second light-emitting control signal line EM2 can control the state of the third transistor 33. For example, when the second light-emitting control signal on the second light-emitting control signal line EM2 is at an active level, the third transistor 33 is turned on and the third light-emitting element D3 emits light. When the second light-emitting control signal on the second light-emitting control signal line EM2 is at a cut-off level, the third transistor 33 is turned off, and the third light-emitting element D3 does not emit light.

The channel area of the first transistor 11 is larger than that of the second transistor 22, and the channel area of the first transistor 11 is larger than that of the third transistor 33.

Exemplarily, FIG. 4 shows that the first sub-pixel includes two first transistors 11, which are a first power supply writing transistor M1_1 and a first light-emitting control transistor M1_2, respectively. The second sub-pixel includes two second transistors 22, which are a second power supply writing transistor M2_1 and a second light-emitting control transistor M2_2, respectively. The third sub-pixel includes two third transistors 33, which are a third power supply writing transistor M3_1 and a third light-emitting control transistor M3_2, respectively.

As an example, the channel area of the at least one first transistor 11 is larger than the channel area of the at least one second transistor 22, and the channel area of the at least one first transistor 11 is larger than the channel area of the at least one third transistor 33.

As another example, the channel area of the first power supply writing transistor M1_1 is larger than the channel area of the second power supply writing transistor M2_1, and the channel area of the first power supply writing transistor M1_1 is larger than the channel area of the third power supply writing transistor M3_1.

As yet another example, the channel area of the first light-emitting control transistor M1_2 is larger than the channel area of the second light-emitting control transistor M2_2, and the channel area of the first light-emitting control transistor M1_2 is larger than the channel area of the third light-emitting control transistor M3_2.

The first light-emitting control signal line is connected to the first sub-pixel, the second light-emitting control signal line is connected to the second sub-pixel and the third sub-pixel, the number of sub-pixels connected to the first light-emitting control signal line is less than the number of sub-pixels connected to the second light-emitting control signal line, and the number of first transistors connected to the first light-emitting control signal line is less than the number of transistors connected to the second light-emitting control signal line. In this embodiment, the channel area of the first transistor is larger than the channel area of any one of the second transistor and the third transistor. Thus, the overall load of the first light-emitting control signal line is increased by increasing the channel area of the first transistor, so that the overall load of the first light-emitting control signal line and the overall load of the second light-emitting control signal line tend to be consistent, and the color cast problem is solved.

In some embodiments, the first transistor 11, second transistor 22 and the third transistor have the same function, the channel area of the first transistor 11 is equal to the sum of the channel area of the second transistor 22 and the channel area of the third transistor 33.

Taking FIG. 4 as an example, the first transistor 11 includes a first power supply writing transistor M1_1 and a first light-emitting control transistor M1_2, the second transistor 22 includes a second power supply writing transistor M2_1 and a second light-emitting control transistor M2_2, and the third transistor 33 includes a third power supply writing transistor M3_1 and a third light-emitting control transistor M3_2. The first power supply writing transistor M1_1, the second power supply writing transistor M2_1, and the third power supply writing transistor M3_1 have the same function, and transmit the power supply signal on the first power supply line PVDD to their respective connected driving transistors. The first light-emitting control transistor M1_2, the second light-emitting control transistor M2_2, and the third light-emitting control transistor M3_2 have the same function and transmit driving signals to their respective connected light-emitting elements.

The channel area of the first power supply writing transistor M1_1 is S1, the channel area of the first light-emitting control transistor M1_2 is S2, the channel area of the second power supply writing transistor M2_1 is S3, the channel area of the second light-emitting control transistor M2_2 is S4, the channel area of the third power supply writing transistor M3_1 is S5, and the channel area of the third light-emitting control transistor M3_2 is S6.

For example,

$$S1 = S3 + S5.$$

For another example,

$$S2 = S4 + S6.$$

In other embodiments, the first sub-pixel includes a plurality of first transistors, the second sub-pixel includes a plurality of second transistors, and the third sub-pixel includes a plurality of third transistors. The channel area of the first transistor refers to the sum of the channel areas of the plurality of first transistors. The channel area of the second transistor is the sum of the channel areas of the plurality of second transistors. The channel area of the third transistor is the sum of the channel areas of the plurality of third transistors.

For example, still taking FIG. 4 as an example, $S1 + S2 = S3 + S4 + S5 + S6$.

In this embodiment, by designing the channel area of the first transistor to be equal to the sum of the channel area of the second transistor and the channel area of the third transistor, the load constituted by the transistor on the first light-emitting control signal line and the load constituted by the transistor on the second light-emitting control signal line are the same, so that the overall load of the first light-emitting control signal line and the overall load of the second light-emitting control signal line can be the same or tend to be the same, and the color cast problem can be solved.

The channel area of the transistor is determined by the channel length and the channel width of the transistor, and the channel area can be adjusted by adjusting at least one of the channel length and the channel width.

In some embodiments, the channel lengths of the first transistor 11, the second transistor 22, and the third transistor 33 having the same function are equal; the channel width of the first transistor 11 is equal to the sum of the channel width of the second transistor 22 and the channel width of the third transistor 33. That is, in the present embodiment, the channel area can be adjusted by adjusting the channel width of the transistor without changing the channel length of the transistor.

Taking FIG. 4 as an example, the first power supply writing transistor M1_1 has a channel length of L1 and a channel width of w1; the first light-emitting control transistor M1_2 has a channel length of L2 and a channel width of w2; the second power supply writing transistor M2_1 has a channel length of L3 and a channel width of w3; the second light-emitting control transistor M2_2 has a channel length of L4 and a channel width of w4; the third power supply writing transistor M3_1 has a channel length of L5 and a channel width of w5; and the third light-emitting control transistor M3_2 has a channel length of L6 and a channel width of w6.

For example,

$$L1 = L3 = L5, \text{ and } w1 = w3 + w5.$$

For another example,

$$L2 = L4 = L6, \text{ and } w2 = w4 + w6.$$

In other embodiments, the first sub-pixel includes a plurality of first transistors, the second sub-pixel includes a plurality of second transistors, and the third sub-pixel includes a plurality of third transistors. The channel width of the first transistor refers to the sum of the channel widths of the plurality of first transistors. The channel width of the second transistor is the sum of the channel widths of the plurality of second transistors. The channel width of the third transistor is the sum of the channel widths of the plurality of third transistors. The channel length of the first transistor refers to the channel length of any one of the first transistors. The channel length of the second transistor refers to the channel length of any one of the second transistors. The channel length of the third transistor refers to the channel length of any one of the third transistors.

For example, still taking FIG. 4 as an example, L1 = L2 = L3 = L4 = L5 = L6, and w1 + w2 = w3 + w4 + w5 + w6.

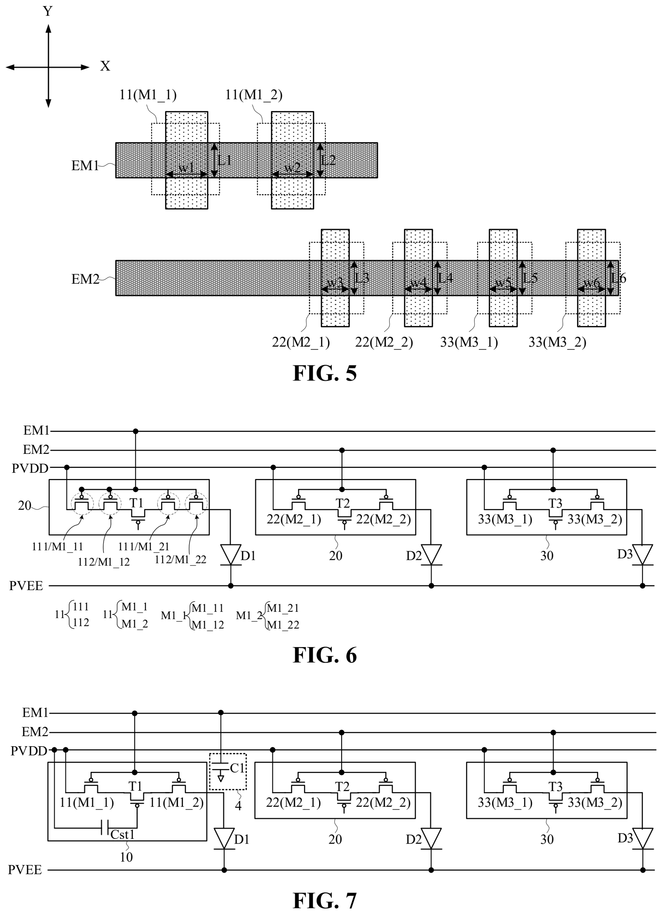

Exemplarily, as shown in FIG. 5, the channel width direction of the first transistor 11 and the extending direction of the first light-emitting control signal line EM1 are the same. The channel width direction of the second transistor 22 and the third transistor 33 and the extending direction of the second light-emitting control signal line EM2 are the same. For example, the first light-emitting control signal line EM1 and the second light-emitting control signal line EM2 extend in the first direction X. In this example, the channel lengths of the respective transistors connected to the light-emitting control signal line are the same, and the channel widths of the respective transistors are adjusted differently, so that the channel areas of different transistors can be adjusted without adjusting the line widths of the first light-emitting control signal line EM1 and the second light-emitting control signal line EM2, which can be easily achieved in the process.

In some embodiments, the channel width of the second transistor 22 and the channel width of the third transistor 33 are equal.

As one example, w3 = w5, w4 = w6, w3 ≠ w4, and w1 + w2 = w3 + w4 + w5 + w6.

For another example,

$$w3 = w4 = w5 = w6, \text{ and } w1 + w2 = w3 + w4 + w5 + w6.$$

For yet another example,

$$w1 = w2 = 2 * w3 = 2 * w4 = 2 * w5 = 2 * w6.$$

For yet another example,

$$w1 \neq w2, \text{ and } w1 + w2 = w3 + w4 + w5 + w6.$$

In the above-described embodiments, it has been described that the load on the first light-emitting control signal line and the load on the second light-emitting control signal line are balanced by differentially designing the channel areas of the transistors to which the light-emitting control signal line is connected in the first sub-pixel and the channel areas of the transistors to which the light-emitting control signal line is connected in the second sub-pixel.

In other embodiments, the number of transistors connected to the light-emitting control signal line in the first sub-pixel and the number of transistors connected to the light-emitting control signal line in the second sub-pixel can be differentiated to achieve load balancing. Some implementations of differentially designing the number of transistors are described below.

As an example, as shown in FIG. 6, the first transistor 11 includes a first sub-transistor 111 and a second sub-transistor 112, the first sub-transistor 111 and the second sub-transistor 112 are connected in series, and the gate of the first sub-transistor 111 and the gate of the second sub-transistor 112 are both connected to the first light-emitting control signal line EM1. The channel area of the first transistor 11 is equal to the sum of the channel areas of the first sub-transistor 111 and the second sub-transistor 112.

In this example, it is equivalent to splitting one first transistor 11 into two subtransistors connected in series, thereby increasing the number of transistors to which the first light-emitting control signal line EM1 is connected.

Exemplarily, FIG. 6 shows that the first sub-pixel includes two first transistors 11, which are a first power supply writing transistor M1_1 and a first light-emitting control transistor M1_2, respectively. The first power supply writing transistor M1_1 includes a first power supply writing sub-transistor M1_11 and a second power supply writing sub-transistor M1_12, and the first light-emitting control transistor M1_2 includes a first light-emitting control sub-transistor M1_21 and a second light-emitting control sub-transistor M1_22.

The first electrode of the first power supply writing sub-transistor M1_11 is connected to the first power supply line PVDD, the second electrode of the first power supply writing sub-transistor M1_11 is connected to the first electrode of the second power supply writing sub-transistor M1_12, and the second electrode of the second power supply writing sub-transistor M1_12 is connected to the first electrode of the first driving transistor T1. The first electrode of the first light-emitting control sub-transistor M1_21 is connected to the second electrode of the first driving transistor T1, the second electrode of the first light-emitting control sub-transistor M1_21 is connected to the first electrode of the second light-emitting control sub-transistor M1_22, and the second electrode of the second light-emitting control sub-transistor M1_22 is connected to the first light-emitting element D1.

The gates of the first power supply writing sub-transistor M1_11, the second power supply writing sub-transistor M1_12, the first light-emitting control sub-transistor M1_21, and the second light-emitting control sub-transistor M1_22 are all connected to the first light-emitting control signal line EM1.

The channel area of the first power supply writing transistor M1_1 is S1, the channel area of the first power supply writing sub-transistor M1_11 is S11, and the channel area of the second power supply writing sub-transistor M1_12 is S12, and S1 = S11 + S12.

The channel area of the first light-emitting control transistor M1_2 is S2, the channel area of the first light-emitting control sub-transistor M1_21 is S21, and the channel area of the second light-emitting control sub-transistor M1_22 is S22, where S2 = S21 + S22.

For example,

$$S11 + S12 = S3 + S5.$$

For another example,

$$S21 + S22 = S4 + S6.$$

For yet another example,

$$S11 + S12 + S21 + S22 = S3 + S4 + S5 + S6.$$

Compared with the example shown in FIG. 4, in FIG. 6, the number of the transistors connected to the first light-emitting control signal line EM1 in the first sub-pixel is increased. As shown in FIG. 6, the first light-emitting control signal line EM1 is connected to four transistors in the first sub-pixel, the second light-emitting control signal line EM2 is connected to two transistors in the second sub-pixel and two transistors in the third sub-pixel, and the number of the transistors connected to the first light-emitting control signal line EM1 is the same as the number of transistors connected to the second light-emitting control signal line EM2, so that the load on the first light-emitting control signal line and the load on the second light-emitting control signal line are balanced.

In some embodiments, with reference to FIGS. 3 and 6, the first sub-transistor 111, the second sub-transistor 112, the second transistor 22, and the third transistor 33 have the same channel area.

Exemplarily,

$$S11 = S12 = S21 = S22 = S3 = S4 = S5 = S6.$$

It can be understood that in this example,

$$S11 + S12 > S3, \ S11 + S12 > S5, \ S21 +$$

S22 > S4, and S21 + S22 > S5, the example still conforms to that the channel area of the first transistor is larger than the channel area of the second transistor, and the channel area of the first transistor is larger than the channel area of the third transistor.

In some embodiments, the first sub-transistor 111, the second sub-transistor 112, the second transistor 22, and the third transistor 33 have the same channel width, and the first sub-transistor 111, the second sub-transistor 112, the second transistor 22, and the third transistor 33 have the same channel length.

Exemplarily, since the first power supply writing sub-transistor M1_11, the second power supply writing sub-transistor M1_12, the first light-emitting control sub-transistor M1_21, the second light-emitting control sub-transistor M1_22, the second power supply writing transistor M2_1, the second light-emitting control transistor M2_2, the third power supply writing transistor M3_1, and the third light-emitting control transistor M3_2 have the same channel length and the same channel width, the loads of the first light-emitting control signal line and the second light-emitting control signal line can be balanced only by adjusting the number of transistors connected to the first light-emitting control signal line in the first sub-pixel.

The above-described embodiment introduces the realization of load balancing by differentiating the number of transistors to which the light-emitting control signal line is connected in the first sub-pixel and the number of transistors to which the light-emitting control signal line is connected in the second sub-pixel. In other embodiments, an additional compensation structure can also be added to achieve the balancing between the load on the first light-emitting control signal line and the load on the second light-emitting control signal line. Some implementations of adding additional compensation structures are described below.

In some embodiments, as shown in FIG. 7, at least one of the first light-emitting control signal line EM1 and the second light-emitting control signal line EM2 is connected with a compensation structure 4 for compensating the load of the light-emitting control signal line to which the compensation structure 4 is connected.

In this embodiment, the compensation structure can be flexibly designed according to the load magnitudes of the first light-emitting control signal line and the second light-emitting control signal line, so that the overall load of the first light-emitting control signal line and the overall load of the second light-emitting control signal line tend to be consistent.

For example, in a case that the load of the first light-emitting control signal line EM1 is less than the load of the second light-emitting control signal line EM2 due to other factors, it can be designed that the first light-emitting control signal line EM1 is connected with the compensation structure 4, and the second light-emitting control signal line EM2 is not connected with the compensation structure. For another example, in a case that the load of the first light-emitting control signal line EM1 is greater than the load of the second light-emitting control signal line EM2 due to other factors, it can be designed that the first light-emitting control signal line EM1 is not connected with the compensation structure, and the second light-emitting control signal line EM2 is connected with the compensation structure 4. In this way, the overall load of the first light-emitting control signal line EM1 and the overall load of the second light-emitting control signal line EM2 can tend to be consistent.

As an example, as shown in FIG. 7, the display panel further includes a third sub-pixel 3 including a third transistor 33, a gate of the third transistor 33 is connected to the second light-emitting control signal line EM2. In this example, the second sub-pixel 2 and the third sub-pixel 3 are both connected to the second light-emitting control signal line EM2, and the number of sub-pixels connected to the second light-emitting control signal line EM2 is greater than the number of sub-pixels connected to the first light-emitting control signal line EM1. In this case, at least the first light-emitting control signal line EM1 is connected with a compensation structure 4 for increasing the load of the first light-emitting control signal line EM1, thereby compensating for the relatively low load caused by the small number of sub-pixels to which the first light-emitting control signal line EM1 is connected, so that the overall load of the first light-emitting control signal line EM1 and the overall load of the second light-emitting control signal line EM2 tend to be consistent.

In some embodiments, as shown in FIG. 7, the compensation structure 4 includes a capacitor. One end of the capacitor is connected to the light-emitting control signal line, and the other end of the capacitor is connected to a fixed voltage signal line (not shown in the drawings). Since the capacitor is charged and discharged through the light-emitting control signal line to which the capacitor is connected, the capacitor constitutes a load of the light-emitting control signal line, and after the capacitor is added, the load of the light-emitting control signal line can be increased.

Exemplarily, the fixed voltage signal line connected to the other end of the capacitor includes any one of the following: a first power supply line PVDD, a second power supply line PVEE, a reset signal line Vref, a high-level signal line VGH, a low-level signal line VGL, and a bias signal line DVH.

In some embodiments, as shown in FIG. 7, the display panel further includes a third sub-pixel 3 including a third transistor 33, a gate of the third transistor 33 is connected to the second light-emitting control signal line EM2. The compensation structure 4 includes at least a first capacitor C1, and the first capacitor C1 is connected to a first light-emitting control signal line EM1. The first capacitor C1 can increase the load of the first light-emitting control signal line EM1, so that the overall load of the first light-emitting control signal line EM1 and the overall load of the second light-emitting control signal line EM2 tend to be consistent.

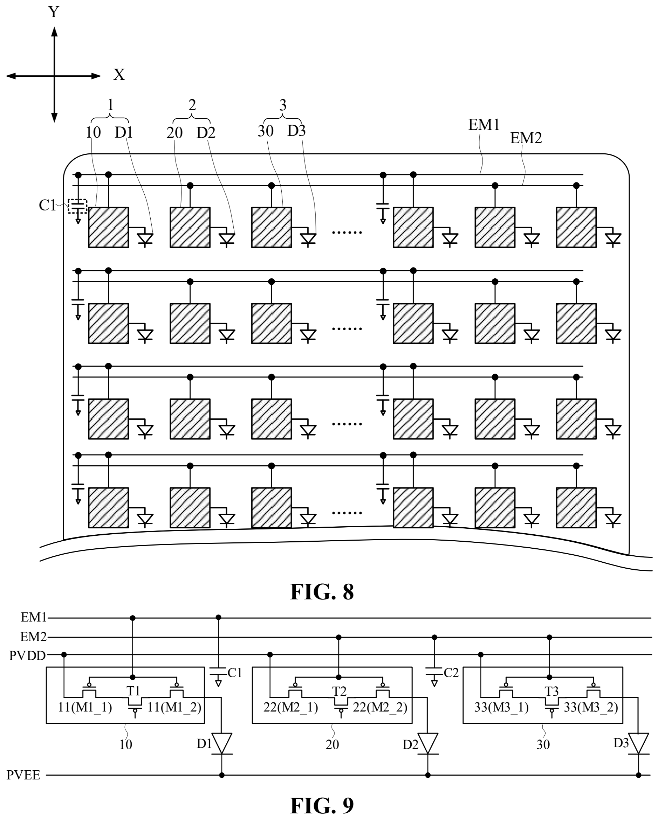

In some embodiments, as shown in FIG. 8, the first capacitor C1 is disposed in one-to-one correspondence with the first sub-pixel 1, and the first capacitor C1 is disposed close to the first sub-pixel 1 corresponding to the first capacitor C1.

Exemplarily, the first light-emitting control signal line EM1 is connected to a plurality of first sub-pixels 1 located in the same row, the number of first sub-pixels 1 connected to the first light-emitting control signal line EM1 is equal to the number of first capacitors C1. A first capacitor C1 is provided for each first sub-pixel 1. In this way, a better signal delay balancing effect can be achieved for each first sub-pixel.

In some embodiments, as shown in FIG. 7, the first sub-pixel further includes a first storage capacitor Cst1. One end of the first storage capacitor Cst1 is connected to the gate of the first driving transistor T1, and the other end of the first storage capacitor Cst1 is connected to the first power supply line PVDD. The capacitance value of the first capacitor C1 is less than the capacitance value of the first storage capacitor Cst1.

The greater the capacitance value of the first capacitor C1, the greater the increased load on the first light-emitting control signal line EM1. In the case that the capacitance value of the first capacitor C1 is too great, the first light-emitting control signal line EM1 may not be able to effectively drive the first sub-pixel. In this embodiment, the capacitance value of the first capacitor C1 is less than the capacitance value of the first storage capacitor Cst1, so as to ensure that the first light-emitting control signal line EM1 can effectively drive the first sub-pixel.

The overlapping area of the two plates of the capacitor affects the capacitance value of the capacitor. Exemplarily, the overlapping area of the two plates of the first capacitor C1 is smaller than the overlapping area of the two plates of the first storage capacitor Cst1, thereby reducing the space occupied by the first capacitor C1 to avoid lowering the resolution of the display panel.

Exemplarily, the two plates of the first capacitor are located in the same film layer as the two electrode plates of the first storage capacitor Cst1.

In other embodiments, as shown in FIG. 9, in addition to adding a first capacitor C1 connected to the first light-emitting control signal line EM1, a second capacitor C2 may be added to be connected to the second light-emitting control signal line EM2, and the capacitance value of the first capacitor C1 is greater than the capacitance value of the second capacitor C2.

In this example, the second sub-pixel 2 and the third sub-pixel 3 are both connected to the second light-emitting control signal line EM2, and the number of sub-pixels connected to the second light-emitting control signal line EM2 is greater than the number of sub-pixels connected to the first light-emitting control signal line EM1. In this case, the capacitance value of the first capacitor C1 is greater than the capacitance value of the second capacitor C2, thereby compensating for the relatively low load due to the small number of sub-pixels to which the first light-emitting control signal line EM1 is connected, so that the overall load of the first light-emitting control signal line EM1 and the overall load of the second light-emitting control signal line EM2 tend to be consistent.

Exemplarily, the two plates of the second capacitor C2 and the two plates of the first capacitor C1 are located in the same film layer.

FIGS. 7 to 9 show an example in which the compensation structure includes a capacitor for illustration. In other embodiments, the compensation structure may also include a resistor, or the compensation structure may include other structures capable of increasing the load.

The impedance of the light-emitting control signal line itself also constitutes the load of the light-emitting control signal line. When the materials of the first light-emitting control signal line and the second light-emitting control signal line are the same, the smaller the line width of the trace is, the greater the impedance of the trace is. Thus, the load of the first light-emitting control signal line and the second light-emitting control signal line can be balanced by differentiating the line widths of the first light-emitting control signal line and the second light-emitting control signal line.

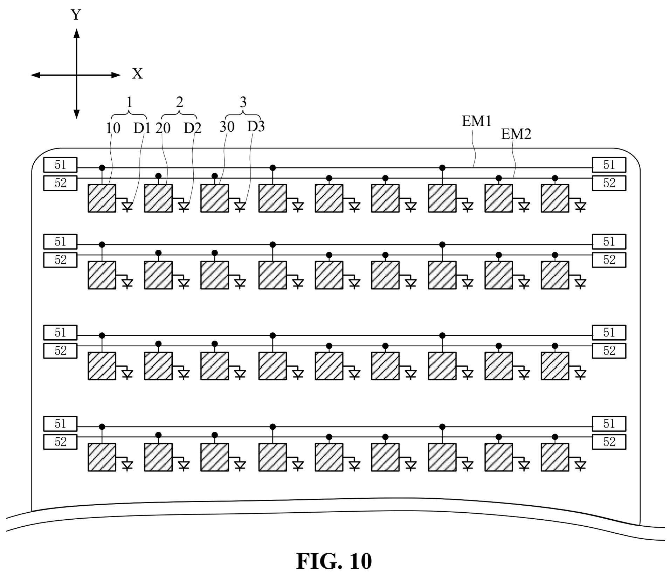

In some embodiments, as shown in FIG. 10, the first light-emitting control signal line EM1 is connected to the first sub-pixel 1, the second light-emitting control signal line EM2 is connected to the second sub-pixel 2 and the third sub-pixel 3, and the line width of the first light-emitting control signal line EM1 is smaller than the line width of the second light-emitting control signal line EM2. In FIG. 10, the second light-emitting control signal line EM2 is illustrated by a relatively thick trace, and the first light-emitting control signal line EM1 is illustrated by a relatively thin trace. Exemplarily, the materials of the first light-emitting control signal line EM1 and the second light-emitting control signal line EM2 are the same.

In this example, the number of sub-pixels connected to the second light-emitting control signal line EM2 is greater than the number of sub-pixels connected to the first light-emitting control signal line EM1. In this case, in a case that the materials of the first light-emitting control signal line EM1 and the second light-emitting control signal line EM2 are the same, the line width of the first light-emitting control signal line EM1 is smaller than the line width of the second light-emitting control signal line EM2. The smaller the line width is, the greater the impedance of the first light-emitting control signal line EM1 is, which is equivalent to increasing the load of the trace, thereby compensating for the relatively low load due to the small number of sub-pixels connected to the first light-emitting control signal line EM1, so that the overall load of the first light-emitting control signal line EM1 and the overall load of the second light-emitting control signal line EM2 tend to be consistent.

Exemplarily, as shown in FIG. 10, the display panel further includes a first drive circuit 51 and a second drive circuit 52, the first drive circuit 51 and the first light-emitting control signal line EM1 are connected, and the second drive circuit 52 and the second light-emitting control signal line EM2 are connected. The first drive circuit 51 is configured to generate a first light-emitting control signal, and the second drive circuit 52 is configured to generate a second light-emitting control signal.

As an example, the circuit topologies of the first drive circuit 51 and the second drive circuit 52 may be the same, and the parameters of transistors having the same function in the first drive circuit 51 and the second drive circuit 52 may be the same. For example, the first drive circuit 51 includes a first output transistor 511 and a second output transistor 512, the second drive circuit 52 includes a third output transistor 521 and a fourth output transistor 522, the first output transistor 511 and the third output transistor 521 are transistors having the same function, and the first output transistor 511 and the third output transistor 521 have the same channel area. The second output transistor 512 and the fourth output transistor 522 are transistors having the same function, and the second output transistor 512 and the fourth output transistor 522 have the same channel area. Exemplarily, the first output transistor 511, the second output transistor 512, the third output transistor 521, and the fourth output transistor 522 have the same channel area.

As another example, the channel areas of the output transistors in the first drive circuit 51 and the second drive circuit 52 may be differentiated to balance the loads on the first light-emitting control signal line and the second light-emitting control signal line. For example, the first output transistor 511 and the third output transistor 521 have different channel areas, and the second output transistor 512 and the fourth output transistor 522 have different channel areas.

For example, the first light-emitting control signal line EM1 is connected to the first sub-pixel 1, the second light-emitting control signal line EM2 is connected to the second sub-pixel 2 and the third sub-pixel 3, the channel area of the first output transistor 511 is larger than the channel area of the third output transistor 521, and the channel area of the second output transistor 512 is larger than the channel area of the fourth output transistor 522.

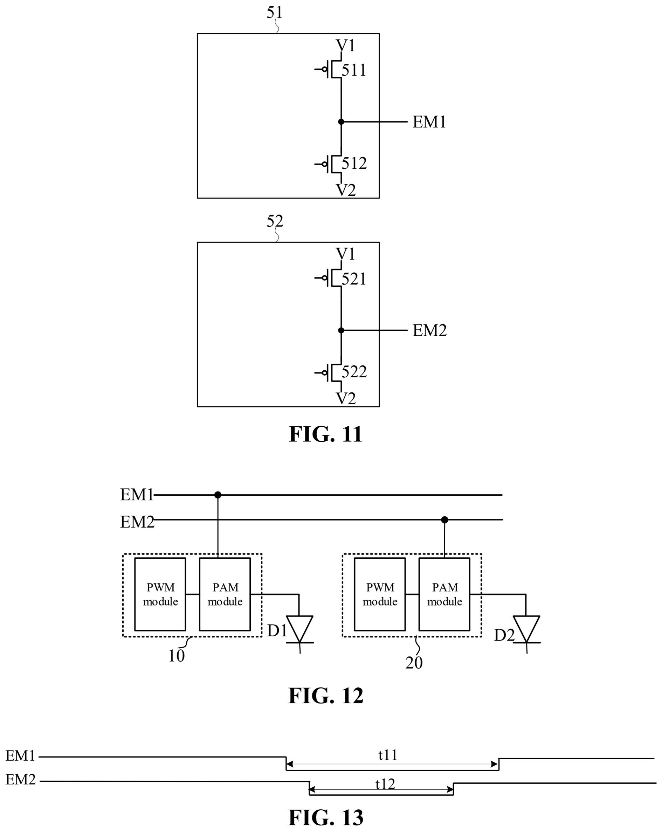

As an example, as shown in FIG. 12, the first pixel circuit 10 and the second pixel circuit 20 each include a Pulse Width Modulation (PWM) module and a Pulse Amplitude Modulation (PAM) module, and the combination of the PWM module and the PAM module can control the intensity of the driving current and the time duration of the driving current to control the light-emitting state of the light-emitting element.

The PWM module and the PAM module are connected. The pixel circuit generates a driving current under the control of the PWM module and the PAM module. The PAM module is configured to control the amplitude of the driving current, and the PWM module is configured to adjust the pulse width of the voltage applied to the first electrode of the light-emitting element.

The PWM module adjusts the pulse width of the voltage applied to the first electrode of the light-emitting element. That is, the PWM module adjusts the actual emission period during which the driving current is applied to the light-emitting element, while maintaining the driving current applied to the light-emitting element at a constant level to adjust the gray scale or brightness displayed by the light-emitting element, instead of adjusting the gray scale or the brightness displayed by the light-emitting element only by adjusting the magnitude of the driving current applied to the light-emitting element. Therefore, the PAM module can supply a driving current to the light-emitting element so that the light-emitting element is driven with optimum light-emitting efficiency, and adjust the light-emitting duty cycle (i.e., the emission period of the light-emitting element) of the light-emitting element through the PWM module to adjust the gray scale or brightness displayed by the light-emitting element.

The PAM module directly determines the magnitude of the driving current, and the PAM module has a great influence on the brightness of the light-emitting element. In the present application, in the case that the pixel circuit includes a PWM module and a PAM module, the first light-emitting control signal line EM1 is connected to the PAM module in the first pixel circuit, and the second light-emitting control signal line EM2 is connected to the PAM module in the second pixel circuit.

In some examples described above, the transistors in different sub-pixels may be differentiated, and in some embodiments, the parameters of a plurality of transistors in the same sub-pixel and connected to the same light-emitting control signal line may also be differentiated.

In some embodiments, as shown in FIG. 4, the first sub-pixel includes a first driving transistor T1 and a first light-emitting element D1, the first transistor 11 includes a first power supply writing transistor M1_1 and a first light-emitting control transistor M1_2, a first electrode of the first power supply writing transistor M1_1 is connected to a first power supply line PVDD, a second electrode of the first power supply writing transistor M1_1 is connected to a first electrode of the first driving transistor T1, the first electrode of the first light-emitting control transistor M1_2 is connected to the second electrode of the first driving transistor T1, and a second electrode of the first light-emitting control transistor M1_2 is connected to the first light-emitting element D1. The gates of the first power supply writing transistor M1_1 and the first light-emitting control transistor M1_2 are connected to the first light-emitting control signal line EM1.

The channel width-to-length ratio of the first power supply writing transistor M1_1 is less than the channel width-to-length ratio of the first light-emitting control transistor M1_2.

The channel width-to-length ratio of the transistor is equal to the ratio of the channel width of the transistor to the channel length of the transistor. Exemplarily, the first power supply writing transistor M1_1 and the first light-emitting control transistor M1_2 have the same channel length, and the channel width of the first power supply writing transistor M1_1 is smaller than the channel width of the first light-emitting control transistor M1_2.

A first electrode of the first power supply writing transistor M1_1 is a source electrode, and a second electrode of the first power supply writing transistor M1_1 is a drain electrode. A first electrode of the first light-emitting control transistor M1_2 is a source electrode, and the second electrode of the first light-emitting control transistor M1_2 is a drain electrode.

The gates of the first power supply writing transistor M1_1 and the first light-emitting control transistor M1_2 are connected to the first light-emitting control signal line EM1, and the gate voltages of the first power supply writing transistor M1_1 and the first light-emitting control transistor M1_2 are the same. Since the first light-emitting control transistor M1_2 is close to the first light-emitting element D1, the first power supply writing transistor M1_1 is close to the first power supply line PVDD, and the source voltage of the first light-emitting control transistor M1_2 is relatively low. Therefore, the absolute value |Vgs| of the gate-source voltage difference of the first light-emitting control transistor M1_2 is small, and in the case that the width-to-length ratio of the first light-emitting control transistor M1_2 is large, both the first power supply writing transistor M1_1 and the first light-emitting control transistor M1_2 can be maintained in a good conduction state.

In some embodiments, as shown in FIGS. 3 and 4, the display panel further includes a third sub-pixel 3 including a third transistor 33, and the gate of the third transistor 33 is connected to the second light-emitting control signal line EM2.

The second sub-pixel includes a second driving transistor T2 and a second light-emitting element D2, and the second transistor 22 includes a second power supply writing transistor M2_1 and a second light-emitting control transistor M2_2. A first electrode of the second power supply writing transistor M2_1 is connected to the first power supply line PVDD, and a second electrode of the second power supply writing transistor M2_1 is connected to the first electrode of the second driving transistor T2. A first electrode of the second light-emitting control transistor M2_2 is connected to a second electrode of the second driving transistor T2, and a second electrode of the second light-emitting control transistor M2_2 is connected to the second light-emitting element D2. The gates of the second power supply writing transistor M2_1 and the second light-emitting control transistor M2_2 are connected to the second light-emitting control signal line EM2.

The third sub-pixel 3 includes a third driving transistor T3 and a third light-emitting element D3. The third transistor includes a third power supply writing transistor M3_1 and a third light-emitting control transistor M3_2. A first electrode of the third power supply writing transistor M3_1 is connected to the first power supply line PVDD, a second electrode of the third power supply writing transistor M3_1 is connected to a first electrode of the third driving transistor T3, a first electrode of the third light-emitting control transistor M3_2 is connected to a second electrode of the third driving transistor T3, and a second electrode of the third light-emitting control transistor M3_2 is connected to the third light-emitting element D3. The gates of the third power supply writing transistor M3_1 and the third light-emitting control transistor M3_2 are connected to the second light-emitting control signal line EM2.

The channel width-to-length ratio of the second power supply writing transistor M2_1 is smaller than the channel width-to-length ratio of the second light-emitting control transistor M2_2, and/or the channel width-to-length ratio of the third power supply writing transistor M3_1 is smaller than the channel width-to-length ratio of the third light-emitting control transistor M3_2.

Exemplarily, the channel length of the second power supply writing transistor M2_1 is equal to the channel length of the second light-emitting control transistor M2_2, and the channel width of the second power supply writing transistor M2_1 is smaller than the channel width of the second light-emitting control transistor M2_2.

Exemplarily, the channel length of the third power supply writing transistor M3_1 is equal to the channel length of the third light-emitting control transistor M3_2, and the channel width of the third power supply writing transistor M3_1 is smaller than the channel width of the third light-emitting control transistor M3_2.

Similarly, since the second light-emitting control transistor M2_2 is close to the second light-emitting element D2, the second power supply writing transistor M2_1 is close to the first power supply line PVDD, and the source voltage of the second light-emitting control transistor M2_2 is relatively low, the absolute value |Vgs| of the gate-source voltage difference of the second light-emitting control transistor M2_2 is relatively small. In the case that the width-to-length ratio of the second light-emitting control transistor M2_2 is great, both the second power supply writing transistor M2_1 and the second light-emitting control transistor M2_2 can be maintained in a good conduction state.

Since the third light-emitting control transistor M3_2 is close to the third light-emitting element D3, the third power supply writing transistor M3_1 is close to the first power supply line PVDD, and the source voltage of the third light-emitting control transistor M3_2 is relatively low, and the absolute value |Vgs| of the gate-source voltage difference of the third light-emitting control transistor M3_2 is small. Therefore, in the case that the width-to-length ratio of the third light-emitting control transistor M3_2 is great, both the third power supply writing transistor M3_1 and the third light-emitting control transistor M3_2 can be maintained in a good conduction state.

In some embodiments, the channel width-to-length ratio of the second power supply writing transistor M2_1 is equal to the channel width-to-length ratio of the third power supply writing transistor M3_1, and/or the channel width-to-length ratio of the second light-emitting control transistor M2_2 is equal to the channel width-to-length ratio of the third light-emitting control transistor M3_2. The second power supply writing transistor M2_1 and the third power supply writing transistor M3_1 are configured to write a power voltage into their respective connected driving transistors, and the two are transistors with the same function. The second light-emitting control transistor M2_2 and the third light-emitting control transistor M3_2 are configured to transmit the driving current to their respective connected light-emitting elements, and the two are transistors with the same function. In this embodiment, the transistors having the same function in the second sub-pixel and the third sub-pixel are designed to have the same channel width-to-length ratio, which may not lead to a large driving difference between the two sub-pixels and may not increase process difficulty.

Exemplarily, the light-emitting elements in the present application include, but are not limited to, micro light-emitting diodes (Micro LEDs) or mini light-emitting diodes (Mini LEDs). LED devices with red, green, and blue colors are required for color display, and there is a difference in luminous efficiency between devices with different colors. The inventors have found that the luminous efficiency of red sub-pixels is greatly different from those of green sub-pixels and blue sub-pixels, and the luminous efficiencies of green sub-pixels and blue sub-pixels are similar.

In some embodiments, the first sub-pixel includes a red sub-pixel, one of the second sub-pixel and the third sub-pixel is a green sub-pixel, and the other is a blue sub-pixel. In this embodiment, the red sub-pixel is separately connected to the first light-emitting control signal line, and the second sub-pixel and the third sub-pixel share the second light-emitting control signal line, so that the light-emitting time duration of the red sub-pixel can be adjusted, thereby compensating for the difference in light-emitting efficiency of different light-emitting elements and improving the display effect of the display panel.

In some embodiments, in the case that the first light-emitting control signal line is connected to the red sub-pixel and the second light-emitting control signal line is connected to the green sub-pixel and the blue sub-pixel, as shown in FIG. 13, in one frame, the time duration t11 of the active level on the first light-emitting control signal line EM1 is greater than the time duration t12 of the active level on the second light-emitting control signal line EM2.

In FIG. 13, the active level is illustrated as a low level, but this is not intended to limit the present application. It is to be understood that in the case that the transistors controlled by the first light-emitting control signal line EM1 and the second light-emitting control signal line EM2 are both N-type transistors, the active levels of the two are both high levels.

Furthermore, in FIG. 13, in one frame, the first light-emitting control signal line EM1 includes one active level, and the second light-emitting control signal line EM2 includes one active level. In other examples, in one frame, the first light-emitting control signal line EM1 may include a plurality of active levels, and the second light-emitting control signal line EM2 may include a plurality of active levels. The total time duration of the plurality of active levels on the first light-emitting control signal line EM1 is greater than the total time duration of the plurality of active levels on the second light-emitting control signal line EM2.

In this embodiment, since the time duration of the active level on the first light-emitting control signal line EM1 is relatively long, so that the light-emitting time duration of the red sub-pixel can be relatively long, thereby compensating for the problem of relatively low light-emitting efficiency of the red sub-pixel.

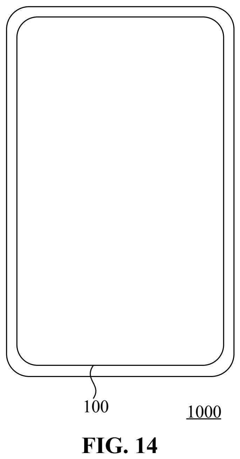

The present application further provides a display apparatus including the display panel provided in the present application. Referring to FIG. 14, FIG. 14 is a schematic structural diagram of a display apparatus according to an embodiment of the present application. The display apparatus 1000 provided in FIG. 14 includes a display panel 100 provided in any one of the above-described embodiments of the present application. In the embodiment of FIG. 14, the display apparatus 1000 is described by only taking a mobile phone as an example. It can be understood that the display apparatus provided in the embodiments of the present application can be another display apparatus having a display function, such as a wearable product, a computer, a television, or an in-vehicle display apparatus, and the present application does not specifically limit this. The display apparatus provided by the embodiments of the present application has the beneficial effects of the display panel provided by the embodiments of the present application. For details, the specific description of the display panel in each of the above embodiments can be referred, and the present embodiment will not be repeatedly described here.

According to the embodiments of the present application as described above, these embodiments are not intended to be exhaustive in all details, nor are they intended to limit the application to the specific embodiments described. It can be apparent that many modifications and variations may be made in light of the above description. The purpose of selecting and specifically describing these embodiments in this specification is to better explain the principles and practical applications of the present application, so that those skilled in the art can make good use of the present application and modifications based on the present application. The present application is limited only by the claims and their full scope and equivalents.

**EP 4 760 687 A1**

**Claims**

1.  A display panel (100), comprising:

    sub-pixels comprising a first sub-pixel (1) and a second sub-pixel (2), the first sub-pixel (1) comprising a first transistor (11), the second sub-pixel (2) comprising a second transistor; and
    light-emitting control signal lines comprising a first light-emitting control signal line and a second light-emitting control signal line,
    wherein a gate of the first transistor (11) is connected to the first light-emitting control signal line, and a gate of the second transistor (22) is connected to the second light-emitting control signal line; and
    a channel area of the first transistor (11) and a channel area of the second transistor (22) are different.

2.  The display panel (100) according to claim 1, wherein the display panel (100) further comprises a third sub-pixel (3) comprising a third transistor (33), a gate of the third transistor (33) being connected to the second light-emitting control signal line; and
    the channel area of the first transistor (11) is larger than the channel area of the second transistor (22), and the channel area of the first transistor (11) is larger than a channel area of the third transistor (33).

3.  The display panel (100) according to claim 2, wherein the channel area of the first transistor (11) is equal to a sum of the channel area of the second transistor (22) and the channel area of the third transistor (33).

4.  The display panel (100) according to claim 3, wherein channel lengths of the first transistor (11), the second transistor (22), and the third transistor (33) are equal; and
    a channel width of the first transistor (11) is equal to a sum of a channel width of the second transistor (22) and a channel width of the third transistor (33).

5.  The display panel (100) according to claim 4, wherein the channel width of the second transistor (22) is equal to the channel width of the third transistor (33).

6.  The display panel (100) according to claim 1, wherein the first transistor (11) comprises a first sub-transistor (111) and a second sub-transistor (112) that are connected in series, and a gate of the first sub-transistor (111) and a gate of the second sub-transistor (112) are connected to the first light-emitting control signal line; and
    the channel area of the first transistor (11) is equal to a sum of a channel area of the first sub-transistor (111) and a channel area of the second sub-transistor (112).

7.  The display panel (100) according to claim 6, wherein the display panel (100) further comprises a third sub-pixel (3) comprising a third transistor (33), a gate of the third transistor (33) being connected to the second light-emitting control signal line, and
    the first sub-transistor (111), the second sub-transistor (112), the second transistor (22), and the third transistor (33) have the same channel area.

8.  The display panel (100) according to claim 7, wherein the first sub-transistor (111), the second sub-transistor (112), the second transistor (22), and the third transistor (33) have a same channel width, and the first sub-transistor (111), the second sub-transistor (112), the second transistor (22), and the third transistor (33) have a same channel length.

9.  The display panel (100) according to claim 1, wherein at least one of the first light-emitting control signal line or the second light-emitting control signal line is connected with a compensation structure for compensating a load of the light-emitting control signal line to which the compensation structure is connected.

10. The display panel (100) according to claim 9, wherein the compensation structure comprises a capacitor, an end of the capacitor is connected to the light-emitting control signal line, and the other end of the capacitor is connected to a fixed voltage signal line.

11. The display panel (100) according to claim 10, wherein the display panel (100) further comprises a third sub-pixel (3) comprising a third transistor (33), a gate of the third transistor (33) is connected to the second light-emitting control signal line; and
    the capacitor comprises at least a first capacitor (C1) connected to the first light-emitting control signal line.

14

**12.** The display panel (100) according to claim 11, wherein the first capacitor (C1) and the first sub-pixel (1) are disposed in one-to-one correspondence, and the first capacitor (C1) is disposed close to the first sub-pixel (1) corresponding to the first capacitor (C1).

**13.** The display panel (100) according to claim 11, wherein the first sub-pixel (1) further comprises a first storage capacitor, a capacitance value of the first capacitor (C1) being less than a capacitance value of the first storage capacitor.

**14.** The display panel (100) according to claim 11, wherein the capacitor further comprises a second capacitor (C2) connected to the second light-emitting control signal line, a capacitance value of the first capacitor (C1) being greater than a capacitance value of the second capacitor (C2).

**15.** The display panel (100) according to claim 2, wherein a line width of the first light-emitting control signal line is smaller than a line width of the second light-emitting control signal line.

**16.** The display panel (100) according to claim 1, wherein the first sub-pixel (1) comprises a first driving transistor and a first light-emitting element (D1), and the first transistor (11) comprises a first power supply writing transistor (M1_1) and a first light-emitting control transistor (M1_2);

the first power supply writing transistor (M1_1) is connected between a first electrode of the first driving transistor and a first power supply line, and the first light-emitting control transistor (M1_2) is connected between a second electrode of the first driving transistor and the first light-emitting element (D1);
a channel width-to-length ratio of the first power supply writing transistor (M1_1) is less than a channel width-to-length ratio of the first light-emitting control transistor (M1_2).

**17.** The display panel (100) according to claim 16, wherein the display panel (100) further comprises a third sub-pixel (3), the third sub-pixel (3) comprising a third transistor (33), a gate of the third transistor (33) being connected to the second light-emitting control signal line;

the second sub-pixel (2) comprises a second driving transistor and a second light-emitting element (D2), the second transistor (22) comprises a second power supply writing transistor (M2_1) and a second light-emitting control transistor (M2_2), the second power supply writing transistor (M2_1) is connected between a first electrode of the second driving transistor and a first power supply line, and the second light-emitting control transistor (M2_2) is connected between a second electrode of the second driving transistor and the second light-emitting element (D2);
the third sub-pixel (3) comprises a third driving transistor and a third light-emitting element (D3), the third transistor (33) comprises a third power supply writing transistor (M3_1) and a third light-emitting control transistor (M3_2), the third power supply writing transistor (M3_1) is connected between a first electrode of the third driving transistor and the first power supply line, and the third light-emitting control transistor (M3_2) is connected between a second electrode of the third driving transistor and the third light-emitting element (D3); and
a channel width-to-length ratio of the second power supply writing transistor (M2_1) is less than a channel width-to-length ratio of the second light-emitting control transistor (M2_2), and/or a channel width-to-length ratio of the third power supply writing transistor (M3_1) is less than a channel width-to-length ratio of the third light-emitting control transistor (M3_2).

**18.** The display panel (100) according to claim 17, wherein the channel width-to-length ratio of the second power supply writing transistor (M2_1) is equal to the channel width-to-length ratio of the third power supply writing transistor (M3_1), and/or
the channel width-to-length ratio of the second light-emitting control transistor (M2_2) is equal to the channel width-to-length ratio of the third light-emitting control transistor (M3_2).

**19.** The display panel (100) according to claim 1, wherein the first sub-pixel (1) comprises a red sub-pixel, one of the second sub-pixel (2) and the third sub-pixel (3) is a green sub-pixel, and the other is a blue sub-pixel.

**20.** The display panel (100) according to claim 19, wherein in one frame, a time duration of an active level on the first light-emitting control signal line is longer than a time duration of an active level on the second light-emitting control signal line.

**21.** A display apparatus (1000), comprising the display panel (100) according to any one of claims 1-20.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

51

V1
511
EM1
512
V2

52

V1
521
EM2
522
V2

**FIG. 11**

EM1
EM2

| PWM module | PAM module | D1 |
| 10 |

| PWM module | PAM module | D2 |
| 20 |

**FIG. 12**

EM1  t11
EM2  t12

**FIG. 13**

EP 4 760 687 A1

100          1000

**FIG. 14**

22

## EUROPEAN SEARCH REPORT

**Application Number**

EP 25 21 4440

### DOCUMENTS CONSIDERED TO BE RELEVANT

| Category | Citation of document with indication, where appropriate, of relevant passages | Relevant to claim |
|---|---|---|
| X | US 2024/074237 A1 (WANG XUANYUN [CN] ET AL) 29 February 2024 (2024-02-29) | 1,2,21 |
| A | * paragraphs [0002], [0066]; figures 1,3,6-9 * | 3-20 |
| | ----- | |
| X | US 2023/215350 A1 (SHI JIAO [CN] ET AL) 6 July 2023 (2023-07-06) | 1,2,21 |
| A | * paragraph [0002]; figures 1-4,16 * | 3-20 |
| | ----- | |
| X | US 7 091 936 B1 (YAMADA TSUTOMU [JP]) 15 August 2006 (2006-08-15) | 1,2,21 |
| A | * column 1, line 6; figures 1-2 * | 3-20 |
| | ----- | |

**CLASSIFICATION OF THE APPLICATION (IPC)**

INV.
G09G3/32

ADD.
H10K59/35

**TECHNICAL FIELDS SEARCHED (IPC)**

G09G

The present search report has been drawn up for all claims

| Place of search | Date of completion of the search | Examiner |
|---|---|---|
| The Hague | 24 February 2026 | Pichon, Jean-Michel |

EPO FORM 1503 03.82 (P04C01)

## ANNEX TO THE EUROPEAN SEARCH REPORT
## ON EUROPEAN PATENT APPLICATION NO.

EP 25 21 4440

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2026

| Patent document cited in search report | | Publication date | Patent family member(s) | | Publication date |
|---|---|---|---|---|---|
| US 2024074237 | A1 | 29-02-2024 | CN | 116259275 A | 13-06-2023 |
| | | | US | 2024074237 A1 | 29-02-2024 |
| US 2023215350 | A1 | 06-07-2023 | CN | 114300531 A | 08-04-2022 |
| | | | US | 2023215350 A1 | 06-07-2023 |
| US 7091936 | B1 | 15-08-2006 | JP | 2001109399 A | 20-04-2001 |
| | | | KR | 20010050816 A | 25-06-2001 |
| | | | TW | 490996 B | 11-06-2002 |
| | | | US | 7091936 B1 | 15-08-2006 |

EPO FORM P0459

For more details about this annex : see Official Journal of the European Patent Office, No. 12/82